(19) **Europäisches Patentamt / European Patent Office / Office européen des brevets**

(11) **EP 3 541 739 B1**

(12) **FASCICULE DE BREVET EUROPEEN**

(45) Date de publication et mention
de la délivrance du brevet:
**22.07.2020 Bulletin 2020/30**

(51) Int Cl.:
**B81B 7/00** (2006.01)

(21) Numéro de dépôt: **17811638.0**

(86) Numéro de dépôt international:
**PCT/FR2017/053166**

(22) Date de dépôt: **20.11.2017**

(87) Numéro de publication internationale:
**WO 2018/091851 (24.05.2018 Gazette 2018/21)**

(54) **SYSTÈME D'AMORTISSEMENT POUR UNE MASSE MOBILE D'UN DISPOSITIF MEMS**

DÄMPFUNGSSYSTEM FÜR EINE MOBILE MASSE EINER MEMS-VORRICHTUNG

DAMPING SYSTEM FOR A MOBILE MASS OF A MEMS DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.11.2016 FR 1661296**

(43) Date de publication de la demande:
**25.09.2019 Bulletin 2019/39**

(73) Titulaires:
• **Safran**
**75015 Paris (FR)**
• **Commissariat à l'Énergie Atomique
et aux Énergies Alternatives
75015 Paris (FR)**

(72) Inventeur: **LEHEE, Guillaume, Jérôme, François
77550 Moissy-Cramayel (FR)**

(74) Mandataire: **Regimbeau
20, rue de Chazelles
75847 Paris Cedex 17 (FR)**

(56) Documents cités:
**WO-A2-2006/127035     US-A1- 2003 018 420
US-B1- 7 194 889**

**Description**

## DOMAINE TECHNIQUE DE L'INVENTION ET ART ANTERIEUR

La présente invention concerne la conception de systèmes mécaniques à éléments mobiles de petites dimensions, notamment au sein de systèmes MEMS (pour Micro Electro-Mechanical Systems) comme des capteurs inertiels de petite taille.

L'une des principales causes de non-fiabilité et de fragilité des dispositifs MEMS est l'entrée en contact desdits éléments mobiles avec des surfaces fixes, lors d'événements vibratoires ou de choc. Ce contact peut d'une part engendrer le collage des éléments mobiles par interaction électrostatique ou de Van der Waals. D'autre part, ces éléments mobiles et les éléments avoisinants sont susceptibles d'être détériorés par des chocs violents et/ou répétés, par exemple lors d'une chute brutale du dispositif MEMS.

Ces problématiques sont d'autant plus pertinentes lorsque les éléments en mouvement ont une masse importante, ou de grandes amplitudes de déplacement : dans les deux cas, l'énergie cinétique du mobile se trouve accrue lorsque la masse est mise en déplacement, et le risque de détérioration du système mobile lors d'un impact avec une surface fixe en regard s'en trouve accru. Cela est notamment le cas au sein de systèmes inertiels de pointe, tels que des accéléromètres ou des gyroscopes, de tels systèmes incluant nécessairement des masses de forte inertie et de grande amplitude de déplacement pour réduire le rapport signal/bruit.

Afin de limiter les risques de collage, il est connu du métier d'implémenter des éléments de butée rigides à la surface d'un mobile de capteur MEMS, de manière à réduire la surface de la zone de contact entre le mobile et un support fixe situé sur sa trajectoire. En effet, l'intensité des interactions à la source du collage est proportionnelle à ladite surface de contact. Toutefois, plus cette surface est faible, et plus les contraintes mécaniques sont concentrées sur cette surface, avec un risque de rupture mécanique accru au niveau de la butée.

Il a été proposé d'introduire dans des capteurs MEMS des butoirs élastiques ou plastiques, flexibles et déformables, en lieu et place d'éléments de butée rigides et indéformables, dans un but non plus d'arrêt brutal de la course du mobile contre un support fixe, mais d'amortissement de la course du mobile, pour ralentir puis arrêter son déplacement. La publication suivante : S. W. Yoon, S. Lee, N. C. Perkins, and K. Najafi, Shock-Protection Improvement Using Integrated Novel Shock-Protection Technologies, Journal of Microelectromechanical Systems, vol. 20, no. 4, pp. 1016-1031, Aug. 2011, propose des butées à comportement élastique ou plastique pour réduire la force de l'impact de poutres sur des surfaces dures au sein de systèmes MEMS.

Cependant, la conception d'éléments de butée à caractère plastique induit une complexité supplémentaire dans le procédé de fabrication des pièces mécaniques. Par ailleurs, un élément mobile en mouvement entrant en contact avec un butoir à comportement purement élastique voit son énergie cinétique convertie en grande partie en énergie potentielle du butoir. Lorsque l'énergie cinétique du mobile atteint zéro, un butoir très élastique peut restituer une grande partie de son énergie potentielle en énergie cinétique du mobile, avec une faible dissipation d'énergie. Le butoir est ainsi susceptible de remettre en mouvement le mobile, et peut engendrer de multiples rebonds de la structure mobile sur des surfaces voisines avec des risques de rupture mécanique.

Pour pallier ce problème, il a été proposé de verrouiller un tel butoir élastique dans sa position déplacée par le mobile, alors qu'il a emmagasiné une partie de l'énergie cinétique du mobile sous forme d'énergie potentielle, afin que cette énergie potentielle ne soit pas restituée au mobile. Le lecteur pourra se référer à la publication suivante : K. Xu, N. Zhu, X. Zhang, W. Su, W. Zhang, and Y. Hao, A novel shock protection method based on MEMS copliant latching stopper, in Proc. IEEE MEMS 2016, 2016, pp. 1125-1128. Le butoir élastique ici implémenté comprend une paire de crochets sur une partie faisant saillie de la surface du butoir, pouvant s'apparier avec des crochets montés sur une paroi faisant face au butoir. Lorsque la masse, dirigée vers la paroi, rentre en contact avec le butoir, ce dernier se déforme, puis est verrouillé mécaniquement par les crochets dans sa position déformée, une fois atteinte une amplitude de déformation critique. Ainsi, lorsque le mobile reprend sa position initiale, le butoir est bloqué et n'est pas en mesure de communiquer son énergie potentielle élastique au mobile. Le butoir ne peut pas être libéré à proximité du mobile et causer des rebonds.

Cette solution, ainsi que d'autres solutions semblables connues de l'état de la technique, présentent toutefois le grave inconvénient de ne pas être utilisables plus d'une fois, le blocage du butoir étant conçu pour être irréversible. A l'occurrence d'un nouvel événement de choc ou de vibration de la structure mécanique, le système de butoir, resté en position bloquée, n'assure plus sa fonction d'amortissement des chocs mécaniques, et peut même en aggraver l'effet. Lorsque le butoir est en position bloquée, l'amplitude d'excursion libre du mobile est augmentée et son énergie cinétique à l'impact peut être accrue.

La demande de brevet internationale WO 2006/127035 A2 présente un capteur de chocs pouvant être implémenté dans un dispositif MEMS, comprenant une masse mobile en translation. Cette masse est dotée d'un crochet pouvant s'engager avec un cliquet, pour maintenir la masse en position verrouillée après un événement de choc et détecter un certain niveau de choc. Ce document prévoit un élément supplémentaire permettant le déblocage de la masse, sous la forme d'un actionneur de déverrouillage pouvant agir sur le cliquet. Le capteur de choc est donc réutilisable pour détecter une succession d'événements de choc. Cependant, aucune fonction d'amortissement du choc entre le mobile et l'élément en regard n'est ici assurée. La complexité du dispositif implémenté dans ce document, et son encombrement, rendent difficile son association avec des éléments d'amortissement du choc subi par le mobile. En outre, l'actionneur de redémarrage qui y est décrit est commandé par contrôle actif, par exemple thermique ou capacitif, et ce document ne propose pas une solution purement mécanique dans un mode de contrôle passif.

Il existe donc un besoin pour une solution de verrouillage d'un butoir élastique dans une micro-structure électromécanique qui prévoie également une étape de déverrouillage du butoir, par contrôle passif ou actif, sans induire une complexité excessive dans la conception.

## DESCRIPTION GENERALE DE L'INVENTION

La présente invention propose, par une conception mécanique adaptée à des systèmes de petites dimensions et un dimensionnement judicieux des éléments mécaniques, un système de contrôle du verrouillage/déverrouillage d'un butoir élastique pour structure micromécanique pouvant fonctionner sur un mode de contrôle passif comme actif, d'usage pertinent dans un dispositif de type MEMS.

Un butoir selon l'invention réalise, en combinaison avec un système de verrouillage/déverrouillage selon l'invention, un cycle d'hystérésis mécanique, le butoir ayant un comportement mécanique non-linéaire par rapport à l'amplitude de déplacement de la masse mobile qu'il amortit. Cependant, l'irréversibilité introduite par le blocage du butoir dans une position verrouillée après un premier événement de choc est traitée par une étape ultérieure de déverrouillage qui peut être contrôlée de manière active ou passive, comme il sera décrit ci-après.

Selon un premier aspect, l'invention concerne un système d'amortissement pour une masse mobile d'un tel dispositif,

le système étant apte à empêcher un contact direct entre la masse et un élément de surface du dispositif MEMS, la masse étant mobile en translation relativement à l'élément de surface suivant une première direction, le système d'amortissement comprenant :

- un butoir mécanique présentant des propriétés élastiques, positionné entre la masse et l'élément de surface,

ledit butoir étant orienté suivant une deuxième direction lorsqu'il est dans une position de repos,
associé à un système de verrouillage/déverrouillage avec les éléments suivants :

• une branche orientée vers le butoir terminée par une extrémité de blocage,
• une liaison pivot apte à faire pivoter la branche selon un axe de rotation perpendiculaire au plan de la plaque sur laquelle sont disposés les éléments du dispositif MEMS,

le système de verrouillage/déverrouillage définissant deux positions de la masse suivant sa direction de translation :

- une position centrale,
- une première position extrême où la masse est rapprochée de l'élément de surface en regard par rapport à sa position centrale, le butoir étant alors pressé vers l'élément de surface suivant une position verrouillée, la branche étant configurée pour bloquer le butoir dans cette position verrouillée par l'intermédiaire de l'extrémité de blocage,

le système de déverrouillage étant en outre configuré pour permettre une rotation du système de verrouillage/déverrouillage autour de la liaison pivot, jusqu'à une position où le butoir n'est pas maintenu en position verrouillée.

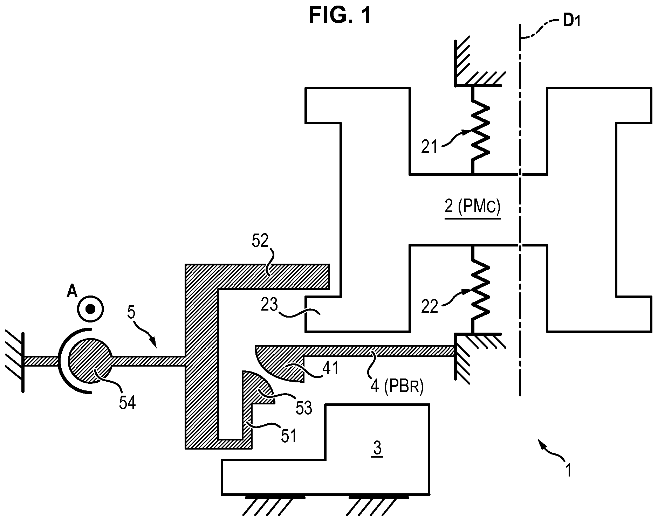

Dans un mode de réalisation correspondant à un contrôle mécanique passif du système de verrouillage/déverrouillage, illustré sur les figures 1 à 9, il est proposé ici un système de verrouillage/déverrouillage comprenant en outre un levier solidaire de la branche et rotatif suivant la même liaison pivot que la branche,
le système d'amortissement comprenant en outre un élément de saillie solidaire de la masse, s'étendant hors de la masse vers ce levier,
de sorte que lors du passage de la masse de la position centrale à une deuxième position extrême, le levier soit entraîné par le mouvement de translation de l'élément faisant saillie et fasse tourner le système de verrouillage/déverrouillage autour de la liaison pivot jusqu'à une position où le butoir n'est pas maintenu en position verrouillée.

Dans un deuxième mode de réalisation correspondant à un contrôle actif du verrouillage et du déverrouillage du butoir, non illustré ici, le contrôle d'une opération de rotation du système de verrouillage/déverrouillage autour de sa liaison pivot peut être assuré par un actionneur, associé par exemple à un actionneur d'une surface en regard du dispositif MEMS. Ces actionneurs peuvent par exemple être des peignes électrostatiques activés électriquement pour moduler la distance entre le système de verrouillage/déverrouillage et une surface en regard, générant une force d'interaction électrostatique suffisante pour faire tourner le système de verrouillage/déverrouillage dans un sens ou dans l'autre autour de sa liaison pivot.

Selon un deuxième aspect, l'invention propose un dispositif MEMS, de type capteur ou actionneur, comprenant un système d'amortissement selon le premier aspect de l'invention. L'invention est d'usage avantageux pour un dispositif MEMS dans lequel une masse est mobile relativement aux éléments avoisinants, et encourt des risques importants de collage mécanique ou de rupture mécanique lors d'un événement de choc avec lesdits éléments.

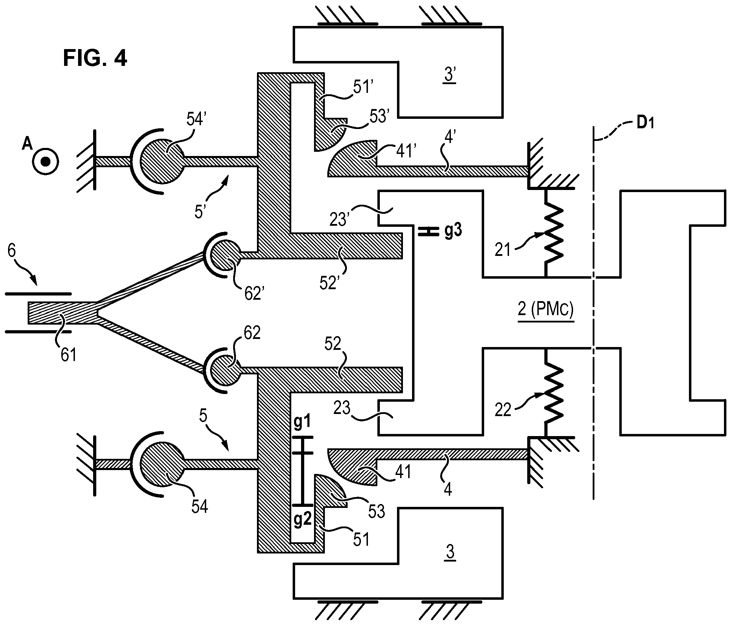

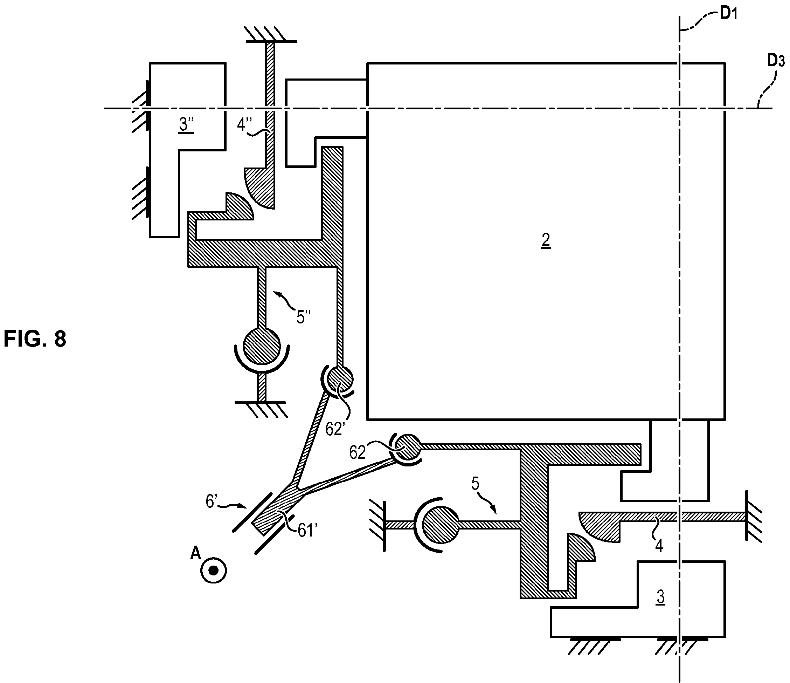

Il est par ailleurs proposé des dispositifs MEMS comportant plusieurs systèmes de verrouillage/déverrouillage, afin d'amortir une masse mobile soit selon plusieurs sens de déplacement sur une même direction de translation (cas illustré sur les figures 4 à 7), soit selon plusieurs directions de translation (cas illustré sur la figure 8).

De manière non limitative et très avantageuse, une telle pluralité de systèmes de verrouillage/déverrouillage peut être associée à un ou plusieurs systèmes de couplage afin de lier les mouvements de rotation des systèmes de verrouillage/déverrouillage en réponse au déplacement de la masse mobile, de manière à améliorer le contrôle passif de l'étape de déverrouillage de la pluralité de butoirs, et d'améliorer la réversibilité de l'étape de verrouillage des butoirs. Un dimensionnement astucieux des éléments de l'invention permet cette synergie entre une pluralité de systèmes de verrouillage/déverrouillage, comme sera décrit ci-après, notamment en référence aux figures 4 à 7.

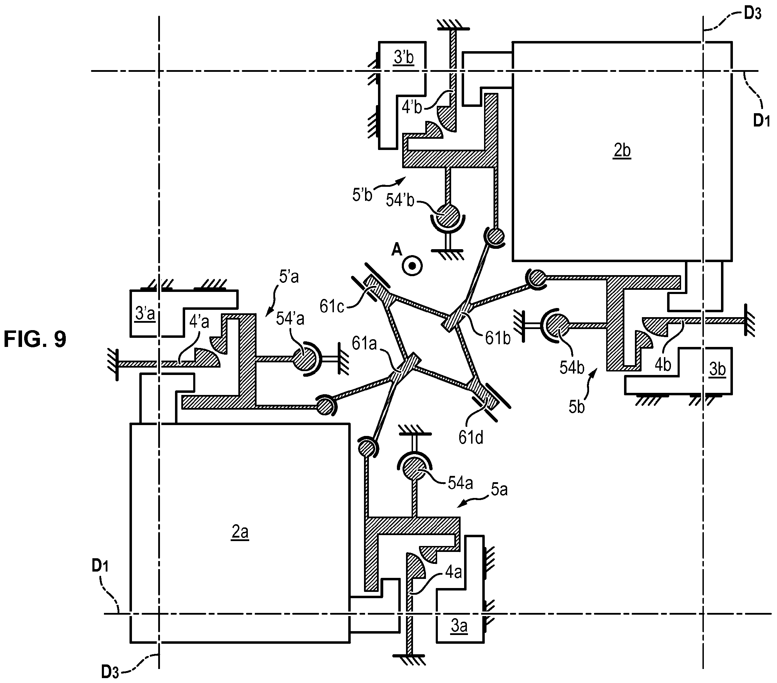

L'invention propose par ailleurs un dispositif MEMS comportant un système d'amortissement prévu pour fonctionner avec un ensemble de deux masses capables de se mouvoir relativement aux éléments de surface avoisinants dans deux directions, lesdites deux masses pouvant ou non être partie d'un même élément mobile. Quatre ensembles de butoirs et systèmes de verrouillage/déverrouillage sont alors réalisés, les quatre systèmes étant couplés comme il sera décrit ci-après en référence à la figure 9.

La présente invention, dont plusieurs exemples de réalisation sont illustrés par les figures qui suivent et détaillés ci-dessous, donne une solution simple à fabriquer et à introduire au sein d'un dispositif MEMS pour assurer le verrouillage et le déverrouillage par contrôle passif ou actif d'un butoir à comportement élastique. La conception très simple du système de verrouillage/déverrouillage proposé ici rend possible son implémentation dans un dispositif MEMS de petites dimensions, dans un objectif de miniaturisation d'un tel dispositif.

Le faible encombrement généré par le système de verrouillage/déverrouillage permet d'implémenter plusieurs de ces systèmes pour amortir un mobile au sein d'un dispositif MEMS selon plusieurs directions de translation, comme exposé ci-dessous. La présente invention rend possible un contrôle actif simultané de plusieurs systèmes de verrouillage/déverrouillage.

La présente invention propose également un ensemble de systèmes d'amortissement tels que définis ci-avant, pour une masse d'un dispositif MEMS mobile susceptible d'entrer en contact avec plusieurs éléments de surface de la structure avoisinante du dispositif MEMS selon une ou plusieurs directions de déplacement en translation.

Par ailleurs, la présente invention propose également un système de couplage de plusieurs systèmes de verrouillage/déverrouillage, à l'aide de pivots et de glissières. Cette dernière solution facilite le contrôle actif simultané de plusieurs systèmes de verrouillage/déverrouillage. En outre, l'usage de deux systèmes de verrouillage/déverrouillage couplés améliore le potentiel de réutilisation d'un butoir lors de nouveaux événements de choc mécanique, comme il sera exposé ci-après.

Il doit être entendu de l'homme du métier que le périmètre d'usage de la présente invention ne se limite pas au cas de mobiles décrivant uniquement une trajectoire en translation au sein d'un dispositif MEMS. L'invention peut être avantageusement utilisée en combinaison avec des mobiles dont le mouvement général comprend des composantes rotatives, mais peut localement être décrit en grande partie comme un mouvement de translation.

## PRESENTATION GENERALE DES FIGURES

D'autres caractéristiques, buts et avantages de la présente invention apparaîtront mieux à la lecture de la description détaillée ci-dessous décrivant plusieurs modes de réalisation avantageux au sein de systèmes MEMS, ainsi qu'à la vue des figures suivantes qui doivent être interprétées à titre purement illustratif et non limitatif.

**La figure 1** représente schématiquement un premier cas où une masse n'est amortie selon une direction de translation que dans un sens, la masse étant présentée dans une position centrale initiale.

**La figure 2** illustre le même dispositif, la masse mobile se trouvant dans une première position extrême basse, le butoir mis en position verrouillée.

**La figure 3** illustre la phase de déverrouillage du butoir lorsque la masse bascule dans une deuxième position extrême haute.

**La figure 4** représente schématiquement un deuxième cas, où deux dispositifs de verrouillage/déverrouillage couplés sont placés de part et d'autre d'une direction de translation d'une masse mobile, ici représentée en position centrale initiale.

**La figure 5** illustre le même dispositif à deux systèmes de verrouillage couplés, lorsque la masse bascule en position basse à partir de l'état du système présenté en figure 4, son contact avec l'élément de bâti en regard étant amorti par le butoir bas.

**La figure 6** illustre, au sein du même dispositif, le retour de la masse en position centrale après l'étape présentée en figure 5, le butoir bas restant bloqué en position verrouillée basse.

**La figure 7** illustre, à partir de l'état du système présenté en figure 6, un basculement de la masse en position extrême haute.

La **figure 8** représente schématiquement un troisième cas, où une masse est mobile selon deux directions de translation sensiblement perpendiculaires et amortie dans un seul sens selon ces deux directions.

La **figure 9** représente schématiquement un quatrième cas, où deux masses sont mobiles selon les deux mêmes directions de translation sensiblement perpendiculaires, et amorties dans un seul sens selon ces deux directions.

## DESCRIPTION DETAILLEE DE MODES DE REALISATION PARTICULIERS

L'ensemble des modes de réalisation ici décrits concernent un dispositif électromécanique de type MEMS comprenant une masse de petites dimensions, qui peut se déplacer relativement à des éléments de surface avoisinants susceptibles de bloquer sa course, dans un mouvement pouvant être localement décrit comme un mouvement de translation. On rappelle que ce mouvement de translation local peut s'inscrire dans un mouvement global de la masse comportant d'autres composantes translatives ou des composantes rotatives ou des contraintes de déformation.

A la **figure 1,** on a représenté une masse mobile 2 d'un dispositif de type MEMS, mobile en translation suivant une direction sensiblement verticale relativement à un élément de surface 3 du dispositif MEMS. Le système d'amortissement ici représenté vise à amortir le mouvement de la masse 2 vers le bas, lorsque celle-ci est animée d'une accélération suffisamment importante pour l'amener en contact avec un butoir 4. Il est entendu que l'on pourrait amortir un mouvement de translation d'une masse suivant toute direction de l'espace.

Selon une caractéristique non essentielle, la masse 2 est ici contrainte en translation par deux éléments de rappel 21 et 22. Le ressort 21 est fixé par une extrémité à une face supérieure de la masse 2, et par une autre extrémité à un élément de surface fixe par rapport à l'élément de surface 3. De même, le ressort 22 est fixé par une extrémité à une face inférieure de la masse 2, et par une autre extrémité à un élément fixe. Ici, les deux ressorts tendent à ramener la masse 2 dans une position centrale $PM_C$, telle qu'illustrée à la figure 1. Il est entendu que la masse 2 pourrait être contrainte en translation selon tout autre moyen utilisable dans un dispositif MEMS. La position centrale $PM_C$ ici représentée peut ici être considérée comme une position de repos de la masse.

Le butoir 4 comprend une lame ressort à comportement élastique s'étendant sensiblement sur un plan perpendiculaire au plan de la figure (donc horizontalement), de faible épaisseur selon la direction verticale, et un élément de pointe 41 d'épaisseur plus importante selon la direction verticale. Dans sa position de repos $PB_R$ présentée ici, c'est-à-dire une position où le butoir 4 est non contraint élastiquement, le butoir 4 s'étend sensiblement sur un plan perpendiculaire à celui de la figure. Le butoir 4 est ici simplement encastré par son extrémité droite dans un élément de surface fixe par rapport à l'élément 3, l'extrémité gauche étant mobile verticalement. Il est encastré verticalement à un niveau qui lui permet de s'étendre entre la masse en position centrale et l'élément de surface 3. Selon un autre mode de réalisation non représenté dans la présente demande, le butoir 4 pourrait être doublement encastré, par exemple être encastré sur son extrémité droite d'une part sur le plan représenté à la figure 1, et d'autre part sur un autre plan parallèle au plan de la figure, en une extrémité gauche. Le butoir 4 est ainsi disposé de manière à s'intercaler entre la masse 2 et l'élément 3 si la masse 2 est dirigée en translation contre l'élément 3. Le butoir 4 est fabriqué dans un matériau présentant des propriétés élastiques et une bonne tenue mécanique, comme du silicium, de la silice, du germanium, du nitrure de silicium, ou un autre matériau semi-conducteur classiquement utilisé dans des dispositifs MEMS.

On a représenté en outre un système de verrouillage/déverrouillage 5. Dans le mode de réalisation ici exposé, et de manière non limitative, le système de verrouillage/déverrouillage 5 effectue un contrôle passif de la position de butoir 4, selon des modalités explicitées par la suite. Le système 5 est formé dans un matériau rigide présentant une bonne tenue mécanique. Il comprend sur sa partie basse une branche 51 en plusieurs parties : une partie s'étendant selon une direction horizontale vers le butoir 4, et une partie s'étendant verticalement et se finissant par un crochet 53, de manière à présenter une concavité globalement orientée vers la droite et à s'étendre sur le chemin de déformation du butoir 4, de sorte qu'un élément qui s'étendrait horizontalement sous le crochet 53 serait limité dans son mouvement vers le haut par le crochet 53. Le système de verrouillage/déverrouillage 5 comprend en outre, sur sa partie haute, un levier 52, relié solidairement à la branche 51, qui s'étend horizontalement vers la masse 2. La branche 51 et le levier 52 forment un ensemble rigide, relié par une liaison pivot 54 à un élément de surface fixe par rapport à l'élément 3, de sorte que le système de verrouillage/déverrouillage 5 est partiellement libre en rotation autour d'un axe sensiblement perpendiculaire au plan de la figure.

Enfin, la masse 2 comporte, sur sa partie basse gauche en regard du levier 52, un élément de saillie 23 dirigé vers le levier 52, rigide et solidaire de la masse 2 dans son mouvement de translation verticale. Le levier 52 et la branche 51 sont dimensionnés et agencés de telle manière que dans la position centrale de la masse 2 représentée ici, l'élément de saillie 23 est disposé entre le levier 52 et le butoir 4 au repos, le crochet 53 étant situé sous le butoir 4 au repos.

Il est à noter que le levier 52 et l'élément de saillie 23 ne sont utiles au sein du système d'amortissement que selon le mode de réalisation assurant un contrôle passif du système de verrouillage/déverrouillage, comme c'est le cas ici. Selon un autre mode de réalisation non représenté par une figure dans la présente demande, des éléments supplémentaires évoqués ci-après peuvent assurer la même fonction que l'élément de saillie 23 et le levier 52 via un contrôle actif.

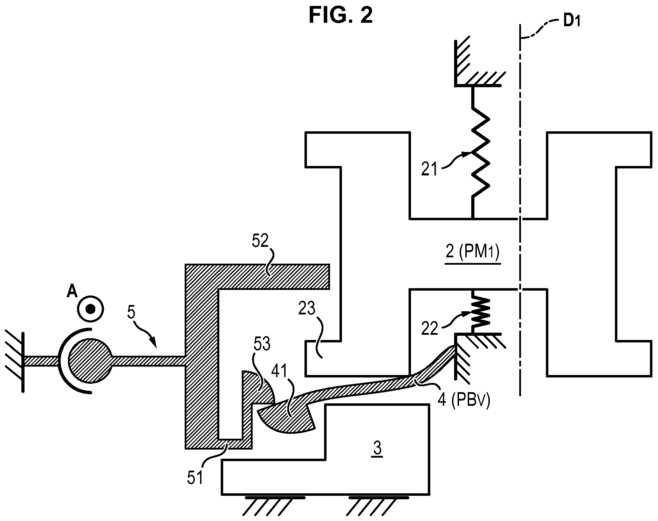

A la **figure 2,** où les numérotations de la figure 1 sont conservées pour les éléments correspondants (ainsi que pour toutes les autres figures), on a représenté la masse 2 dans une position translatée basse $PM_1$, prise comme une première position extrême du système, le ressort bas 22 travaillant en compression et le ressort 21 en détente. La position $PM_1$ est suffisamment translatée par rapport à la position centrale $PM_C$ pour que le butoir 4, entraîné par la course de la masse 2 vers le bas, ait été basculé dans une position verrouillée $PB_V$. Dans cette position verrouillée, le butoir 4 ne s'étend plus dans son entier sur un plan sensiblement perpendiculaire au plan vertical, mais est déplacé vers le bas tout en restant encastré par son extrémité droite non mobile. Ainsi, l'extrémité mobile 41 du butoir 4 est passée sous le crochet 53 de la branche 51 en regard, et l'élément de saillie 23 s'est éloigné du levier 52 par rapport à la position centrale $PM_C$ de la masse 2. Lors du mouvement de la masse 2 de la position $PM_C$ à la position $PM_1$, l'énergie cinétique de la masse 2, liée à sa vitesse en translation, est partiellement convertie en énergie potentielle élastique de la lame ressort du butoir 4, de raideur $k_b$, et est partiellement convertie en énergie potentielle élastique des ressorts 21 et 22 contraints dans une position qui n'est pas leur position de repos, pris de raideur k. Lors d'une remontée vers le haut de la masse 2, sans dépasser un état de la masse 2 où l'élément de saillie 23 vient buter contre le levier 52, le butoir 4 reste bloqué sous le crochet 53 (cet état de remontée vers le haut de la masse 2 n'est pas représenté ici). Ainsi, l'énergie potentielle élastique emmagasinée par le butoir 4 n'est pas restituée sous forme d'énergie cinétique à la masse 2, et seule l'énergie potentielle emmagasinée par les ressorts 21 et 22 est susceptible de l'être. En notant $\eta$ le rendement énergétique vu pour la masse 2 au cours des étapes susnommées de descente, puis de remontée de la masse 2, en notant x (non représenté) l'amplitude de déplacement vertical maximale de la masse 2 par rapport à la position centrale PMC et $g_b$ la distance verticale (non représentée) entre le bord bas de la masse 2 et la surface supérieure du butoir 4, on peut avoir

$$\eta = \frac{E_{ressort}}{E_{ressort}+E_{butoir}} = \frac{kx^2}{kx^2+k_b(x-g_b)^2}.$$

Du fait du blocage du butoir 4, on a un rendement $\eta$ strictement inférieur à 1. L'énergie cinétique de la masse 2 dans son mouvement vers le bas ne lui est pas intégralement restituée, avec l'avantage que la masse 2 n'est pas susceptible de rebondir verticalement à la relâche du butoir 4 lors d'une remontée de la masse 2, entre l'élément de surface 3 et un élément de surface en regard, non représenté ici. Un rendement énergétique $\eta$ inférieur à 95% peut déjà être considéré comme significatif pour éviter cet effet de rebonds, le système présenté ici permettant théoriquement d'aller à un rendement aussi bas que 50%.

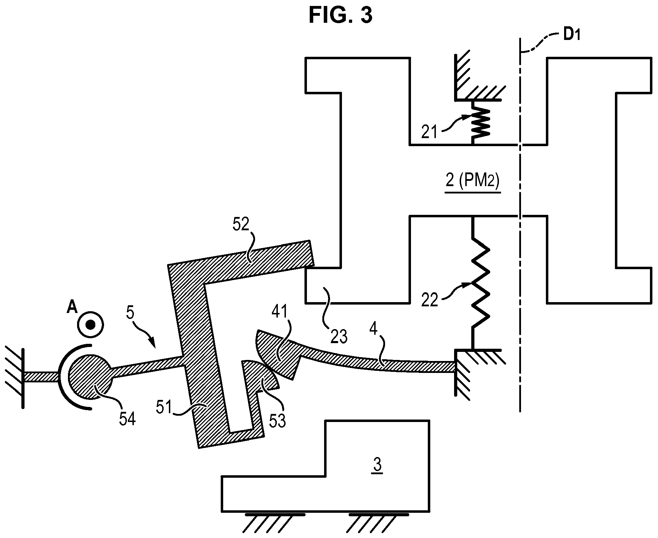

**La figure 3** illustre, pour le même dispositif, la montée de la masse 2 vers une position haute prise comme deuxième position extrême $PM_2$. La position $PM_2$ est suffisamment haute pour que, dans sa course de sa position centrale $PM_C$ à sa position haute $PM_2$, la masse 2 entraîne via l'élément de saillie 23 le levier 52, qui du fait de son indéformabilité entraîne en rotation vers le haut le système de verrouillage/déverrouillage 5 via la liaison pivot 54. La branche 51 et en particulier le crochet 53, solidaires du levier 52, sont entraînés en rotation vers le haut, jusqu'à une position où le crochet 53 est suffisamment soulevé pour que l'extrémité 41 du butoir 4 ne soit plus bloquée en position verrouillée $PB_V$. Le butoir 4 est ainsi relâché et dissipe son énergie potentielle élastique stockée lors de l'étape de descente de la masse 2 illustrée à la figure 2. Avantageusement, cette énergie n'est pas restituée à la masse 2 et n'est donc pas susceptible d'occasionner des rebonds de la masse 2.

Dans ce mode de réalisation où il y a contrôle passif du déverrouillage du système de verrouillage/déverrouillage 5, le déverrouillage du butoir 4 après un passage en position verrouillée $PB_V$ ne peut être obtenu que si la masse 2 remonte suffisamment dans une étape ultérieure pour que l'élément de saillie 23 vienne entraîner vers le haut le levier 52, par exemple en position haute $PM_2$. Si, après la première position extrême basse $PM_1$, la masse 2 remonte vers une position qui ne remplit pas cette condition, par exemple vers la position centrale $PM_C$ vers laquelle elle est spontanément contrainte par les moyens de rappel 21 et 22, le butoir 4 n'est pas débloqué et son efficacité pour amortir un choc ultérieur vers le bas de la masse 2 est compromise.

Dans un autre mode de réalisation où il y aurait contrôle actif du déverrouillage du système de verrouillage/déverrouillage 5, non représenté dans la présente demande, des moyens d'actionnement électronique peuvent être disposés sur le système de verrouillage/déverrouillage 5, par exemple sur le levier 52, et sur une surface en regard, pour permettre la conversion d'un signal électrique d'entrée en action mécanique de rotation vers le haut de la branche 51 autour du pivot 54. Par exemple, des électrodes de polarité différente placées d'une sur une partie haute du levier 52, d'autre part sur une surface fixe en regard, peuvent former un actionneur électrostatique adapté. Dans ce mode à contrôle actif, l'élément de saillie 23 n'est plus essentiel au déverrouillage et peut être omis. Par ailleurs, le déverrouillage n'est alors a priori plus conditionné par la remontée de la masse 2 à une position haute particulière, et on peut avantageusement établir un seuil de déverrouillage du butoir 4 à une position de la masse 2 plus basse que la position haute $PM_2$.

Un second mode de réalisation d'un ensemble de systèmes d'amortissement est présenté sur les **figures 4 à 8.** Dans ce mode de réalisation, la masse 2, mobile en translation suivant une direction sensiblement verticale, est amortie non seulement dans son mouvement vers le bas comme dans le mode de réalisation précédent, mais aussi dans son mouvement vers le haut relativement à un deuxième élément de surface 3' d'un dispositif MEMS, par un deuxième système de verrouillage/déverrouillage 5' associé à un deuxième butoir élastique 4'. La structure et l'agencement du deuxième système de verrouillage/déverrouillage 5' et du butoir 4' reprennent en tous points, de manière symétrique par rapport à un plan perpendiculaire au plan de la figure 4, ceux du système de verrouillage/déverrouillage 5 et du butoir 4. Il est cependant à noter que le dimensionnement et l'agencement des éléments correspondant à l'amortissement du mouvement vers le haut de la masse 2 pourraient aussi être différents, si la structure du dispositif MEMS le nécessite, tant que la fonctionnalité du système de verrouillage/déverrouillage 5' selon les modalités décrites précédemment est conservée.

Il convient de noter que dans le cas représenté aux figures 4 à 8, les deux systèmes de verrouillage/déverrouillage 5 et 5' et les deux butoirs élastiques 4 et 4' amortissent le déplacement de la masse 2 sur un seul et même axe de translation vertical, les deux butoirs 4 et 4' étant disposés de part et d'autre de la masse 2 sur sa direction de déplacement. Cependant, il est également possible d'amortir par deux systèmes de verrouillage/déverrouillage des mouvements de translation selon deux directions distinctes, comme exposé ci-après et illustré en particulier en figure 8.

Le dispositif présenté en **figure 4** comprend, à ce titre, en plus des éléments déjà identifiés dans les figures précédentes, les éléments suivants : élément de surface 3', butoir 4' également encastré sur son extrémité droite, ayant son extrémité gauche 41' libre, système de verrouillage/déverrouillage 5' comprenant une branche 51' dotée d'un crochet extrémal 53' et un levier 52', en rotation autour d'une liaison pivot 54', le levier 52' pouvant entrer en interaction avec un élément de saillie 23' rigide et solidaire de la masse 2 dans son mouvement.

Le fonctionnement de ces divers éléments pris en combinaison ne sera pas à nouveau détaillé ici. En revanche, pour reprendre le vocabulaire et les termes décrits précédemment, il convient de noter qu'une première position extrême basse $PM_1$ de la masse 2 pour le butoir 4, telle que définie ci-avant, correspond à une deuxième position extrême de la masse 2 pour le butoir 4', et une deuxième position extrême haute $PM_2$ de la masse 2 pour le butoir 4 correspond à une première position extrême de la masse 2 pour le butoir 4'.

Une séquence d'étapes successives de positionnement vertical de la masse 2 est détaillée ci-après.

Selon un mode de réalisation alternatif non représenté ici, un système d'amortissement fonctionnel pour les deux directions de translation haute et basse ne comprend pas d'éléments de couplage supplémentaires entre les deux systèmes de verrouillage/déverrouillage 5 et 5'.

Selon un autre mode de réalisation très avantageux représenté sur la figure 4 et les figures suivantes, l'ensemble de systèmes d'amortissement comprend en outre un système de couplage 6 entre les deux systèmes de verrouillage/déverrouillage 5 et 5'. Le système de couplage 6 est lié aux deux systèmes de verrouillage/déverrouillage 5 et 5' respectivement par la liaison pivot 62, située sur une partie haute du système de verrouillage/déverrouillage 5, par exemple dans la continuité du levier 52, et par la liaison pivot 62', située sur une partie basse du système de verrouillage/déverrouillage 5', par exemple dans la continuité du levier 52'. Le système de couplage 6 comprend également une glissière 61, liée aux deux liaisons pivot 62 et 62'. Les degrés de liberté du système de couplage 6 sont contraints par la glissière 61, de manière à n'autoriser que la translation de la glissière 61 suivant un axe sensiblement horizontal. De cette manière, un mouvement de rotation du système de verrouillage/déverrouillage 5 autour de sa liaison pivot 54, notamment un mouvement de rotation vers le haut, entraîne un mouvement de rotation de même angle en sens inverse du système de verrouillage/déverrouillage 5' autour de sa liaison pivot 54' en sens inverse, et inversement. Des avantages de cette configuration seront exposés ci-après et explicités par les figures suivantes.

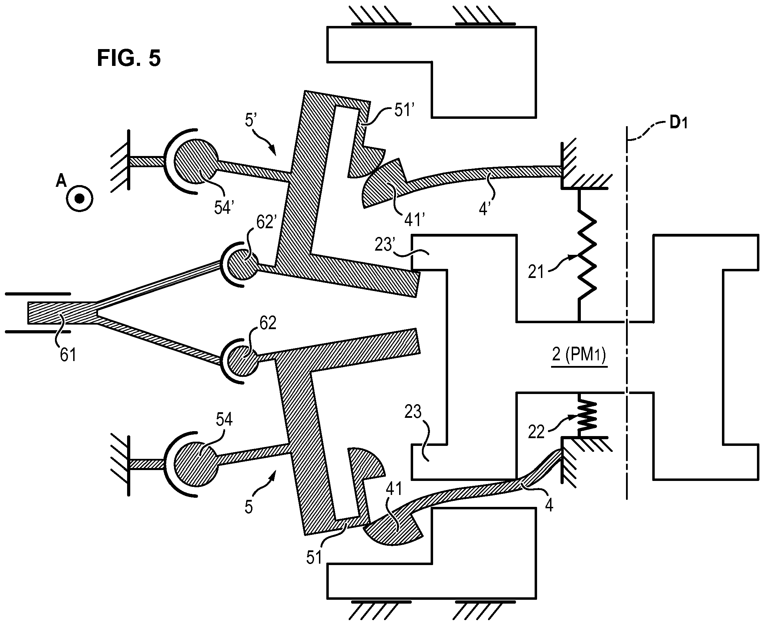

**La figure 5** représente le même dispositif, lorsque la masse 2 atteint une première position extrême basse $PM_1$ pour le butoir 4. La figure 5 correspond ainsi à la même étape que la figure 2 pour le butoir 4 et le système de verrouillage/déverrouillage 5. Le comportement de ces éléments est équivalent au comportement déjà décrit ci-avant en reprenant la figure 2, à ceci près que le système de verrouillage/déverrouillage 5, contraint sur sa liaison pivot 62, a suivi une rotation vers le haut autour de sa liaison pivot 54. La branche 51 est ainsi tournée vers le haut, mais le butoir 4 reste en position basse, contraint par la masse 2 qui vient buter contre l'élément de surface 3.

Cette rotation du système de verrouillage/déverrouillage 5 est causée par une translation de la glissière 61, elle-même causée par une rotation vers le bas du système de verrouillage/déverrouillage 5' autour de sa liaison pivot 54'. En effet, dans sa course vers sa position extrême basse $PM_1$, la masse 2, via l'élément de saillie 23', a entraîné vers le bas le levier 54'. Tout se passe pour le système de verrouillage/déverrouillage 5' et le butoir 4' à l'image de la situation présentée en figure 3 pour le système de verrouillage/déverrouillage 5 et le butoir 4. Le butoir 4', qui était dans l'état présenté en figure 4 dans une position de repos sensiblement horizontale, est entraîné vers le bas par la course de la branche 51', mais cela n'a pas d'effet à ce stade du déplacement de la masse 2.

Des distances $g_1$ et $g_2$ sont représentées, pour plus de clarté, en figure 4. La surface supérieure du butoir 4 et l'élément de saillie 23 sont à la distance $g_1$. La surface supérieure du butoir 4 et l'élément de surface 3 sont à la distance $g_2$. Une amplitude $g_1 + g_2$ de mouvement vers le bas de la masse 2 permet alors le verrouillage du butoir 4 en position verrouillée $PB_V$.

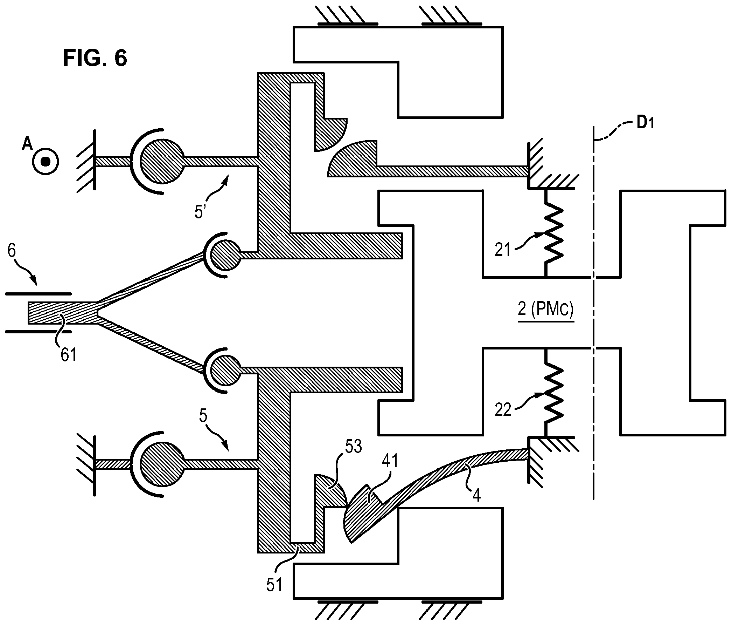

**La figure 6** représente, toujours pour le même système, le retour de la masse 2 à sa position centrale $PM_C$ après passage par les états illustrés sur les figures 4 et 5. Le système est revenu à un état semblable à celui illustré en figure 4, à ceci près que le butoir 4 est bloqué dans sa position verrouillée $PB_V$, par son extrémité libre gauche 41 qui est bloquée sous le crochet 53.

A partir de la figure 6, les figures de la présente demande illustrent un passage à deux états possibles.

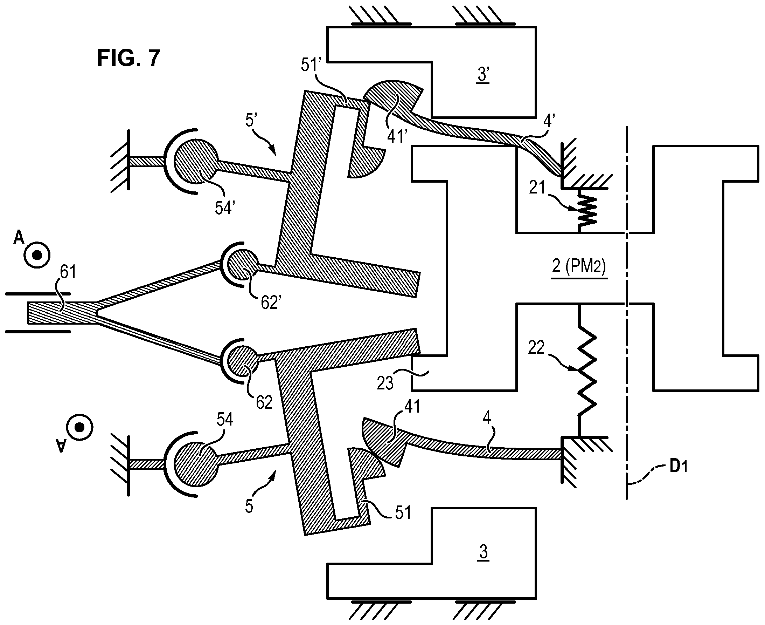

Sur **la figure 7,** la masse 2 est montée vers une deuxième position extrême haute $PM_2$ pour le butoir 4. La figure 7 correspond ainsi à la même étape que la figure 3 pour le butoir 4 et le système de verrouillage/déverrouillage 5. Le comportement de ces éléments est équivalent au comportement déjà décrit ci-avant en reprenant la figure 3. Le butoir 4 est libéré de sa position verrouillée $PB_V$, et est en mesure d'amortir la masse 2 si elle est de nouveau déplacée vers le bas.

Par ailleurs, le passage de la masse 2 dans sa position extrême haute $PM_2$ occasionne le passage en position verrouillée du deuxième butoir 4', la masse 2 venant presser le butoir 4' contre l'élément de surface 3'. Du fait du couplage des liaisons pivot 62 et 62', le système de verrouillage/déverrouillage 5' est entraîné vers le bas par la course vers le haut du système de verrouillage/déverrouillage 5 mis en position déverrouillée, mais cela n'a pas d'effet avantageux sur le butoir 4'.

En revanche, lors du passage du système de l'état présenté à la figure 6 à un nouvel état semblable à celui présenté en figure 5, où la masse 2 retourne en position basse $PM_1$ une deuxième fois après être repassée une deuxième fois en position centrale $PM_C$, le butoir 4 est libéré de sa position verrouillée $PB_V$ avant que la masse 2 ne finisse sa course vers le bas et ne presse le butoir 4 contre l'élément de surface 3.

Ce déverrouillage du butoir 4, lors d'un nouveau passage de la masse 2 en position basse $PM_1$ après un état où le butoir 4 est en position verrouillée $PB_V$, constitue un important avantage du mode de réalisation ici présenté comprenant le système de couplage 6.

Ceci est permis par le dimensionnement de l'ensemble de systèmes d'amortissement, qui prévoit que le levier 52' soit entraîné par l'élément de saillie 23' dans la course vers le bas de la masse 2, occasionnant la levée de la branche 51, avant que la masse 2 n'atteigne une position où le butoir 4 n'est plus en mesure de quitter sa position verrouillée $PB_V$.

Les contraintes de dimensionnement sur l'ensemble pour permettre cet enchaînement d'étapes sont, pour plus de clarté, illustrées par les distances $g_1$ et $g_3$ que donne à voir la figure 4. Pour rappel, la surface supérieure du butoir 4 et l'élément de saillie 23 sont à la

distance $g_1$ Par ailleurs, la surface supérieure du levier 52' et l'élément de saillie 23' sont à la distance verticale $g_3$. Le déverrouillage du butoir 4 avant son blocage par la masse 2 est permis par le fait que la distance $g_1$ soit strictement supérieure à la distance $g_3$.

Un ensemble de systèmes d'amortissement incluant une solution de couplage de deux systèmes de verrouillage/déverrouillage, permet donc une réversibilité améliorée du verrouillage des butoirs élastiques. Après un mouvement de la masse 2 dans un sens donné occasionnant le verrouillage d'un butoir, il suffit, par exemple, d'un retour de la masse 2 à sa position centrale pour déverrouiller l'un quelconque des deux butoirs 4 et 4', alors qu'en l'absence de système de couplage, un passage de la masse 2 à une position extrémale dans l'autre sens bien au-delà de sa position centrale aurait été nécessaire au déverrouillage.

Un troisième mode de réalisation d'un ensemble de systèmes d'amortissement est présenté en **figure 8,** qui reprend partiellement les références données en figures 4 à 8 pour désigner des éléments de même fonction. Ici, un système de couplage 6' est implémenté entre deux systèmes de verrouillage/déverrouillage 5 et 5", qui visent respectivement à amortir d'éventuels chocs de la masse 2 contre deux éléments de surface 3 et 3". Une différence de l'ensemble illustré ici avec celui des figures 4 à 8 est que pour venir buter contre l'élément de surface 3", la masse 2 ne doit pas effectuer un mouvement de translation selon la même direction que pour buter contre l'élément de surface 3. Les deux systèmes de verrouillage/déverrouillage 5 et 5" et les deux butoirs élastiques respectifs 4 et 4" ne sont donc plus disposés de part et d'autre de la masse 2 selon une même direction de translation, mais sur deux directions de translation distinctes, une direction verticale $D_1$ et une direction horizontale $D_3$, de surcroît perpendiculaires ici. Le système de couplage 6', comprenant une glissière 61' et deux liaisons pivot 62 et 62' sur les deux systèmes de verrouillage respectifs 5 et 5', fonctionne de manière équivalente au système de couplage 6 des figures 4 à 8, à ceci près que le mouvement en translation de la glissière ne se fait pas sur un axe sensiblement horizontal, mais sur un axe faisant un angle de sensiblement 45° avec la direction horizontale.

**La figure 9** représente un quatrième mode de réalisation de forme élaborée, concernant deux masses 2a et 2b d'un dispositif MEMS, constitutives ou non d'un même élément mobile en mouvement, mobiles chacune suivant une direction horizontale $D_1$ et suivant une direc-tion verticale $D_3$.

La masse 2a est amortie suivant la direction $D_1$ vers la droite par le système de verrouillage/déverrouillage 5a et le butoir 4a contre l'élément 3a, et suivant la direction $D_3$ vers le haut par le système de verrouillage/déverrouillage 5'a et le butoir 4'a contre l'élément 3'a. La masse 2b est amortie suivant la direction $D_3$ vers le bas par le système de verrouillage/déverrouillage 5b et le butoir 4b contre l'élément 3b, et suivant la direction $D_1$ vers la gauche par le système de verrouillage/déverrouillage 5'b et le butoir 4'b contre l'élément 3'b. Le système illustré ici présente une symétrie selon deux axes diagonaux perpendiculaires entre eux. Chaque masse est ainsi amortie dans un seul sens selon chaque direction de translation.

Par ailleurs, une solution de couplage 6 élaborée est implémentée entre les quatre systèmes de verrouillage/déverrouillage 5a, 5b, 5'a, 5'b. Une première glissière 61a crée un couplage entre les systèmes de verrouillage/déverrouillage 5a et 5'a, et une deuxième glissière 61b crée un couplage entre les systèmes de verrouillage/déverrouillage 5b et 5'b. En outre, un degré de liberté supplémentaire du système formé par les deux glissières 61a et 61b et leurs liaisons pivot respectives avec les quatre systèmes de verrouillage/déverrouillage 5a, 5b, 5'a, 5'b est contraint par deux glissières 61c et 61d, de telle sorte que les translations de la glissière 61a et de la glissière 61b ne sont pas mutuellement indépendantes. Un effet de cet agencement et de cette solution de couplage 6 est de coupler en temps réel les rotations des quatre systèmes de verrouillage/déverrouillage 5a, 5b, 5'a, 5'b, de telle sorte que leurs rotations respectives autour de leurs liaisons pivot 54a, 54b, 54'a, 54'b respectives respectent à tout instant la symétrie selon les deux axes diagonaux visible sur la figure 9.

## Revendications

1. Système d'amortissement pour une masse (2) mobile d'un dispositif MEMS (1),
le système étant apte à empêcher un contact direct entre la masse (2) et un élément de surface (3) du dispositif MEMS (1), la masse (2) étant mobile en translation relativement à l'élément de surface (3) suivant une première direction ($D_1$), le système d'amortissement comprenant :

- un butoir mécanique (4) présentant des propriétés élastiques, positionné entre la masse (2) et l'élément de surface (3),
le butoir (4) étant orienté suivant une deuxième direction lorsqu'il est dans une position de repos ($PB_R$),
- un système de verrouillage/déverrouillage (5) du butoir (4),

le système d'amortissement étant **caractérisé en ce que** le système de verrouillage/déverrouillage (5) comprend :

• une branche (51) orientée vers le butoir (4), comprenant une extrémité de blocage (53),
• une liaison pivot (54) apte à faire pivoter la branche (51) selon un axe (A) de rotation sensiblement perpendiculaire à la première direction ($D_1$) et à la deuxième direction,

le système de verrouillage/déverrouillage (5) définissant les deux positions suivantes de la masse (2) suivant la première direction ($D_1$) de translation :

- une position centrale ($PM_C$) de la masse (2), la masse (2) étant sollicitée dans ladite position centrale (PMC) par des moyens de rappel (21, 22), chacun lié à la masse et à une structure du dispositif MEMS fixe par rapport à l'élément de surface (3),
- une première position extrême ($PM_1$) où la masse (2) est rapprochée de l'élément de surface (3) par rapport à sa position centrale ($PM_C$), le butoir (4) étant alors pressé vers l'élément de surface (3) suivant une position verrouillée ($PB_V$), la branche (51) étant configurée pour bloquer le butoir (4) dans cette position verrouillée ($PB_V$) par son extrémité de blocage (53),

le système de verrouillage/déverrouillage pouvant tourner autour de la liaison pivot (54), jusqu'à une position où le butoir (4) n'est pas maintenu en position verrouillée ($PB_V$).

2. Système d'amortissement selon la revendication 1, dans lequel le système de verrouillage/déverrouillage (5) comprend en outre un levier (52) solidaire de la branche (51) et rotatif suivant la liaison pivot (54), le système d'amortissement comprenant en outre un élément de saillie (23) solidaire de la masse (2), faisant saillie hors de la masse (2) vers le levier (52), le levier (52) et l'élément faisant saillie (23) étant configurés pour que lors du passage de la masse (2) de la position centrale ($PM_C$) à une deuxième position extrême ($PM_2$), le levier (52) soit entraîné par le mouvement de translation de l'élément faisant saillie (23) et fasse tourner le système de verrouillage/déverrouillage (5) autour de la liaison pivot (54) jusqu'à une position où le butoir (4) n'est pas maintenu en position verrouillée ($PB_V$).

3. Système d'amortissement selon la revendication 1 ou 2, comprenant en outre un actionneur positionné au voisinage de la branche (51), capable d'entraîner la branche par contrôle actif, la faisant tourner autour de la liaison pivot (54) jusqu'à une position où le butoir (4) n'est pas maintenu en position verrouillée ($PB_V$) par la branche.

4. Système d'amortissement selon la revendication 3, où l'actionneur positionné au voisinage de la branche est un actionneur électrostatique commandé électroniquement.

5. Système d'amortissement selon l'une des revendications 1 à 4, dans lequel le butoir est constitué d'une poutre (4) encastrée par une extrémité de poutre sur une première surface du dispositif MEMS solidaire de l'élément de surface (3), pouvant être également encastrée par une deuxième extrémité de poutre à une deuxième surface du dispositif MEMS.

6. Dispositif MEMS de type actionneur ou capteur, comportant un système d'amortissement selon l'une des revendications 1 à 5.

7. Dispositif MEMS selon la revendication 6, **caractérisé en ce qu'**il comporte plusieurs systèmes d'amortissement selon l'une quelconque des revendications 1 à 5.

8. Dispositif MEMS selon la revendication 7, dans lequel, pour empêcher un contact direct entre la masse (2) et un premier élément de surface (3) ainsi qu'un deuxième élément de surface (3'), les deux éléments de surface (3, 3') étant situés de part et d'autre de la masse (2) selon la première direction ($D_1$), les butoirs (4, 4') et les systèmes de verrouillage/déverrouillage (5, 5') de deux systèmes d'amortissement sont agencés de part et d'autre de la masse (2) selon la première direction ($D_1$).

9. Dispositif MEMS selon la revendication 7, dans lequel la masse (2) est mobile en translation relativement à un deuxième élément de surface (3") suivant une troisième direction ($D_3$) distincte de la première direction ($D_1$), un système d'amortissement étant disposé pour empêcher le contact direct entre la masse (2) et le premier élément de surface (3) selon la première direction ($D_1$), et un autre système d'amortissement étant disposé pour empêcher le contact direct entre la masse (2) et le deuxième élément de surface (3") selon la troisième direction ($D_3$).

10. Dispositif MEMS selon l'une des revendications 7 à 9, comprenant en outre un système de couplage (6) entre les systèmes de verrouillage/déverrouillage (5, 5') de deux systèmes d'amortissement, le système de couplage étant configuré pour qu'une rotation d'un système de verrouillage/déverrouillage (5) autour de son pivot (54), telle que le butoir (4) associé audit système de verrouillage/déverrouillage (5) ne soit pas maintenu en position verrouillée, entraîne une rotation de l'autre système de verrouillage/déverrouillage (5') autour de son pivot (54') jusqu'à une position où le butoir (4') associé à cet autre système de verrouillage/déverrouillage (5') n'est pas non plus maintenu en position verrouillée.

11. Dispositif MEMS selon la revendication 10, dans lequel le système de couplage (6) comprend

- deux pivots de couplage (62, 62') solidaires respectivement des deux systèmes de verrouillage/déverrouillage (5, 5'), aptes à faire pivoter respectivement les deux systèmes de verrouillage/déverrouillage (5, 5') selon un axe (A) de rotation sensiblement perpendiculaire à la première direction ($D_1$) et à la deuxième direction,
- une glissière (61) liée aux deux pivots de couplage (62, 63) mobile principalement en translation.

12. Dispositif MEMS selon les revendications 8 et 10 prises en combinaison, dans lequel les leviers et les éléments solidaires de la masse des systèmes d'amortissement sont configurés pour que lors du passage de la masse (2) de la position centrale ($PM_C$) à la première position extrême ($PM_1$) de l'un des systèmes d'amortissement, le levier (52') de l'autre système d'amortissement soit entraîné par un élément de saillie (23') de cet autre système et fasse tourner le système de verrouillage/déverrouillage (5') de cet autre système autour de sa liaison pivot (54') jusqu'à une position où le butoir (4') correspondant n'est pas maintenu en position verrouillée ($PB_V$).

**Patentansprüche**

1. Dämpfungssystem für eine mobile Masse (2) einer MEMS-Vorrichtung (1),
wobei das System geeignet ist, einen direkten Kontakt zwischen der Masse (2) und einem Oberflächenelement (3) der MEMS-Vorrichtung (1) zu verhindern, wobei die Masse (2) in Bezug auf das Oberflächenelement (3) gemäß einer ersten Richtung ($D_1$) verschiebbar ist, wobei das Dämpfungssystem umfasst:

- einen mechanischen Anschlag (4), der elastische Eigenschaften aufweist und zwischen der Masse (2) und dem Oberflächenelement (3) positioniert ist,
wobei der Anschlag (4) gemäß einer zweiten Richtung ausgerichtet ist, wenn er sich in einer Ruheposition ($PB_R$) befindet,
- ein System zur Verriegelung/Entriegelung (5) des Anschlags (4),

wobei das Dämpfungssystem **dadurch gekennzeichnet ist, dass** das System zur Verriegelung/Entriegelung (5) umfasst:

• einen Zweig (51), der zu dem Anschlag (4) gerichtet ist, umfassend ein Blockierende (53),
• eine Schwenkverbindung (54), die geeignet ist, den Zweig (51) gemäß einer Drehachse (A), die im Wesentlichen senkrecht zu der ersten Richtung ($D_1$) und zu der zweiten Richtung verläuft, schwenken zu lassen,

wobei das System zur Verriegelung/Entriegelung (5) die folgenden zwei Positionen der Masse (2) gemäß der ersten Verschiebungsrichtung ($D_1$) definiert:

- eine Mittelposition ($PM_C$) der Masse (2), wobei die Masse (2) in der Mittelposition (PMC) von Rückstellmitteln (21, 22) beansprucht wird, die jeweils mit der Masse und mit einer feststehenden Struktur der MEMS-Vorrichtung in Bezug auf das Oberflächenelement (3) verbunden sind,

- eine erste Endposition ($PM_1$), wo die Masse (2) dem Oberflächenelement (3) in Bezug auf ihre Mittelposition ($PM_C$) angenähert ist, wobei der Anschlag (4) dann zu dem Oberflächenelement (3) gemäß einer verriegelten Position ($PB_V$) gedrückt wird, wobei der Zweig (51) ausgestaltet ist, den Anschlag (4) in dieser verriegelten Position ($PB_V$) durch sein Blockierende (53) zu blockieren,

wobei sich das System zur Verriegelung/Entriegelung um die Schwenkverbindung (54) bis in eine Position drehen kann, wo der Anschlag (4) nicht in verriegelter Position ($PB_V$) gehalten wird.

2. Dämpfungssystem nach Anspruch 1, wobei das System zur Verriegelung/Entriegelung (5) weiter einen Hebel (52) umfasst, der mit dem Zweig (51) fest verbunden ist und gemäß der Schwenkverbindung (54) drehbar ist,
wobei das Dämpfungssystem weiter ein Überstandselement (23) umfasst, das mit der Masse (2) fest verbunden ist und außerhalb der Masse (2) zu dem Hebel (52) hin hervorsteht,
wobei der Hebel (52) und das Überstandselement (23) so ausgestaltet sind, damit beim Übergang der Masse (2) von der Mittelposition ($PM_C$) in eine zweite Endposition ($PM_2$) der Hebel (52) durch die Verschiebungsbewegung des Überstandselements (23) angetrieben wird und das System zur Verriegelung/Entriegelung (5) um die Schwenkverbindung (54) bis in eine Position drehen lässt, wo der Anschlag (4) nicht in verriegelter Position ($PB_V$) gehalten wird.

3. Dämpfungssystem nach Anspruch 1 oder 2, weiter umfassend einen Aktor, der in der Nähe des Zweigs (51) positioniert und fähig ist, den Zweig durch aktive Steuerung anzutreiben, wobei er ihn um die Schwenkverbindung (54) bis in eine Position drehen lässt, wo der Anschlag (4) nicht in verriegelter Position ($PB_V$) durch den Zweig gehalten wird.

4. Dämpfungssystem nach Anspruch 3, wobei der Aktor, der in der Nähe des Zweigs positioniert ist, ein elektrostatischer Aktor ist, der elektronisch gesteuert wird.

5. Dämpfungssystem nach einem der Ansprüche 1 bis 4, wobei der Anschlag von einem Balken (4) gebildet wird, der von einem Balkenende auf einer ersten Oberfläche der MEMS-Vorrichtung, die mit dem Oberflächenelement (3) fest verbunden ist, eingefasst wird, wobei er ebenfalls von einem zweiten Balkenende auf einer zweiten Oberfläche der MEMS-Vorrichtung eingefasst werden kann.

6. MEMS-Vorrichtung vom Typ Aktor oder Sensor, umfassend ein Dämpfungssystem nach einem der Ansprüche 1 bis 5.

7. MEMS-Vorrichtung nach Anspruch 6, **dadurch gekennzeichnet, dass** sie mehrere Dämpfungssysteme nach einem der Ansprüche 1 bis 5 umfasst.

8. MEMS-Vorrichtung nach Anspruch 7, wobei, um einen direkten Kontakt zwischen der Masse (2) und einem ersten Oberflächenelement (3) sowie einem zweiten Oberflächenelement (3') zu verhindern, die zwei Oberflächenelemente (3, 3') auf beiden Seiten der Masse (2) gemäß der ersten Richtung ($D_1$) angeordnet sind, die Anschläge (4, 4') und die Systeme zur Verriegelung/Entriegelung (5, 5') von zwei Dämpfungssystemen auf beiden Seiten der Masse (2) gemäß der ersten Richtung ($D_1$) angeordnet sind.

9. MEMS-Vorrichtung nach Anspruch 7, wobei die Masse (2) in Bezug auf ein zweites Oberflächenelement (3") gemäß einer dritten Richtung ($D_3$) verschiebbar ist, die sich von der ersten Richtung ($D_1$) unterscheidet, wobei ein Dämpfungssystem angeordnet ist, um den direkten Kontakt zwischen der Masse (2) und dem ersten Oberflächenelement (3) gemäß der ersten Richtung ($D_1$) zu verhindern, und ein anderes Dämpfungssystem angeordnet ist, um den direkten Kontakt zwischen der Masse (2) und dem zweiten Oberflächenelement (3'') gemäß der dritten Richtung ($D_3$) zu verhindern.

10. MEMS-Vorrichtung nach einem der Ansprüche 7 bis 9, weiter umfassend ein Kopplungssystem (6) zwischen den Systemen zur Verriegelung/Entriegelung (5, 5') von zwei Dämpfungssystemen,
wobei das Kopplungssystem so ausgestaltet ist, damit eine Drehung eines Systems zur Verriegelung/Entriegelung (5) um seinen Schwenkzapfen (54), so dass der Anschlag (4), der mit dem System zur Verriegelung/Entriegelung (5) verbunden ist, nicht in verriegelter Position gehalten wird, eine Drehung des anderen Systems zur Verriegelung/Entriegelung (5') um seinen Schwenkzapfen (54') bis in eine Position bewirkt, wo der Anschlag (4'), der mit diesem anderen System zur Verriegelung/Entriegelung (5') verbunden ist, auch nicht in verriegelter Position gehalten wird.

**11.** MEMS-Vorrichtung nach Anspruch 10, wobei das Kopplungssystem (6) umfasst

- zwei Kopplungsschwenkzapfen (62, 62'), die jeweils mit den zwei Systemen zur Verriegelung/Entriegelung (5, 5') fest verbunden und geeignet sind, jeweils die zwei Systeme zur Verriegelung/Entriegelung (5, 5') gemäß einer Drehachse (A) schwenken zu lassen, die im Wesentlichen senkrecht zu der ersten Richtung (D₁) und zu der zweiten Richtung verläuft,
- eine Gleitschiene (61), die mit den zwei Kopplungsschwenkzapfen (62, 63) verbunden und hauptsächlich verschiebbar ist.

**12.** MEMS-Vorrichtung nach den Ansprüchen 8 und 10 in Kombination, wobei die Hebel und die Elemente, die mit der Masse der Dämpfungssysteme fest verbunden sind, so ausgestaltet sind, damit beim Übergang der Masse (2) von der Mittelposition (PM$_C$) in die erste Endposition (PM₁) von einem der Dämpfungssysteme der Hebel (52') des anderen Dämpfungssystems von einem Überstandselement (23') dieses anderen Systems angetrieben wird und das System zur Verriegelung/Entriegelung (5') dieses anderen Systems um seine Schwenkverbindung (54') bis in eine Position drehen lässt, wo der entsprechende Anschlag (4') nicht in verriegelter Position (PB$_V$) gehalten wird.

## Claims

**1.** A damping system for a mobile mass (2) of a MEMS device (1),
the system being capable of preventing direct contact between the mass (2) and a surface element (3) of the MEMS device (1), the mass (2) being mobile in translation relative to the surface element (3) along a first direction (D₁), the damping system comprising:

- a mechanical stopper (4) having elastic properties, positioned between the mass (2) and the surface element (3),

the stopper (4) being oriented in a second direction when it is in a rest position (PB$_R$),

- a system (5) for locking/unlocking the stopper (4),

the damping system being **characterised in that** the locking/unlocking system (5) comprises:

- a branch (51) oriented towards the stopper (4), comprising a blocking end (53),
- a pivot link (54) capable of pivoting the branch (51) about an axis (A) of rotation substantially perpendicular to the first direction (D₁) and to the second direction,

the locking/unlocking system (5) defining the following two positions of the mass (2) along the first direction of translation (D₁):

- a central position (PM$_C$) of the mass (2), the mass (2) being biased in said central position (PM$_C$) by return means (21, 22), each linked to the mass and to a structure of the MEMS device fixed relative to the surface element (3),
- a first extreme position (PM₁) where the mass (2) is brought closer to the surface element (3) relative to its central position (PM$_C$), the stopper (4) then being pressed towards the surface element (3) in a locked position (PB$_V$), the branch (51) being configured to block the stopper (4) in this locked position (PB$_V$) by its blocking end (53),

the locking/unlocking system being able to rotate about the pivot link (54), to a position where the stopper (4) is not held in the locked position (PB$_V$).

**2.** The damping system according to claim 1, wherein the locking/unlocking system (5) further comprises a lever (52) integral with the branch (51) and rotatable along the pivot link (54),
the damping system further comprising a protrusion element (23) integral with the mass (2), protruding out of the mass (2) towards the lever (52),
the lever (52) and the protruding element (23) being configured so that during the passage of the mass (2) from the central position (PM$_C$) to a second extreme position (PM₂), the lever (52) is driven by the translational movement of the protruding element (23) and rotates the locking/unlocking system (5) along the pivot link (54) to a position where the stopper (4) is not held in the locked position (PB$_V$).

**3.** The damping system according to claim 1 or 2, further comprising an actuator positioned in the vicinity of the branch (51), capable of driving the branch by active control, rotating it along the pivot link (54) to a position where the stopper (4) is not held in the locked position (PB$_V$) by the branch.

**4.** The damping system according to claim 3, where the actuator positioned in the vicinity of the branch is an electronically controlled electrostatic actuator.

**5.** The damping system according to one of claims 1 to 4, wherein the stopper consists of a beam (4) affixed by a beam end on a first surface of the MEMS device integral with the surface element (3), which can also be embedded by a second beam end to a second surface of the MEMS device.

**6.** An actuator or sensor type MEMS device, including a damping system according to one of claims 1 to 5.

**7.** The MEMS device according to claim 6, **characterised in that** it includes several damping systems according to any one of claims 1 to 5.

**8.** The MEMS device according to claim 7, wherein, in order to prevent a direct contact between the mass (2) and a first surface element (3) as well as a second surface element (3'), the two surface elements (3, 3') being located on either side of the mass (2) in the first direction ($D_1$), the stoppers (4, 4') and the locking/unlocking systems (5, 5') of two damping systems are arranged on either side of the mass (2) in the first direction ($D_1$).

**9.** The MEMS device according to claim 7, wherein the mass (2) is mobile in translation relative to a second surface element (3") along a third direction ($D_3$) distinct from the first direction ($D_1$), a damping system being disposed to prevent direct contact between the mass (2) and the first surface element (3) in the first direction ($D_1$), and another damping system being disposed to prevent direct contact between the mass (2) and the second surface element (3") in the third direction ($D_3$).

**10.** The MEMS device according to one of claims 7 to 9, further comprising a coupling system (6) between the locking/unlocking systems (5, 5') of two damping systems,
the coupling system being configured so that a rotation of a locking/unlocking system (5) about its pivot (54), such that the stopper (4) associated with said locking/unlocking system (5) is not held in the locked position, causes a rotation of the other locking/unlocking system (5') about its pivot (54') to a position where the stopper (4') associated with this other locking/unlocking system (5') is also not held in the locked position.

**11.** The MEMS device according to claim 10, wherein the coupling system (6) comprises

- two coupling pivots (62, 62') respectively integral with the two locking/unlocking systems (5, 5'), capable of pivoting respectively the two locking/unlocking systems (5, 5') about an axis (A) of rotation substantially perpendicular to the first direction ($D_1$) and to the second direction,
- a slide (61) linked to the two coupling pivots (62, 63) mobile mainly in translation.

**12.** The MEMS device according to claims 8 and 10 taken in combination, wherein the levers and the elements integral with the mass of the damping systems are configured so that, when switching the mass (2) from the central position ($PM_C$) to the first extreme position ($PM_1$) of one of the damping systems, the lever (52') of the other damping system is driven by a protrusion element (23') of this other system and rotates the locking/unlocking system (5') of this other system about its pivot link (54') to a position where the corresponding stopper (4') is not held in the locked position ($PB_V$).

FIG. 1

**FIG. 2**

EP 3 541 739 B1

FIG. 3

**FIG. 4**

EP 3 541 739 B1

FIG. 5

FIG. 6

EP 3 541 739 B1

FIG. 7

FIG. 8

FIG. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006127035 A2

**Littérature non-brevet citée dans la description**

- **S. W. YOON ; S. LEE ; N. C. PERKINS ; K. NAJAFI.** Shock-Protection Improvement Using Integrated Novel Shock-Protection Technologies. *Journal of Microelectromechanical Systems,* Août 2011, vol. 20 (4), 1016-1031

- **K. XU ; N. ZHU ; X. ZHANG ; W. SU ; W. ZHANG ; Y. HAO.** A novel shock protection method based on MEMS copliant latching stopper. *Proc. IEEE MEMS,* 2016, vol. 2016, 1125-1128